# EUROPEAN PATENT APPLICATION

(11) **EP 1 843 196 A1**
(43) Date of publication of application: **10.10.2007**
(21) Application number: 07007159.2
(22) Date of filing: 05.04.2007
(51) Int. Cl.: G02F 1/1362

(54) **Thin film transistor substrate and method of fabricating the same**

(30) Priority: 06.04.2006 KR 20060031507
(71) Applicant: Samsung Electronics Co., Ltd., Yeongtong-gu Suwon-city, Gyeonggi-do 442-742 (KR)
(72) Inventor: Ning, Hong-Iong, Gyeonggi-do (KR); Jeong, Chang-oh, Gyeonggi-do (KR); Lee, Je-hun, Seoul (KR); Kim, Do-hyun, Seoul (KR); Cho, Sung-hen, Seoul (KR); Song, Ki-yong, Seoul (KR)
(74) Representative: Dr. Weitzel & Partner

(57) **Abstract**

A method of fabricating a thin film transistor (TFT) substrate includes forming a gate line and a data line on an insulating substrate. The data line crosses the gate line and is insulated from the gate line. The formation of the gate line, the data line, or both the gate line and the data line includes forming a low-resistive conductive pattern (21b) on a base pattern (21a) using an electroless plating method.

## Description

### BACKGROUND OF THE INVENTION

### Field of the Invention

The present invention relates to a method of fabricating a liquid crystal display (LCD) device and method of fabricating the same, and more particularly, to a thin film transistor substrate and a method of fabricating a thin film transistor (TFT) substrate of an LCD device. Discussion of the Background

Liquid crystal display (LCD) devices, which are one of the most widely used flat panel display devices, include two substrates having a plurality of electrodes and a liquid crystal layer interposed between the two substrates. LCD devices adjust the amount of light transmitted therethrough by applying a voltage to the plurality of electrodes so that liquid crystal molecules of the liquid crystal layer can be rearranged.

Commonly used LCD devices include a thin film transistor (TFT) substrate, which has a plurality of pixel electrodes arrayed in a matrix, and a display substrate, which has a single common electrode.

In order to meet the ever-increasing demand for wide screens, data lines or gate lines may be formed of a low-resistive conductive material so that a data signal or a gate signal applied to a pixel electrode or a switching element on a TFT substrate can be adequately transmitted to all pixel electrodes or switching elements that are connected to the data and gate lines, regardless of the distance the signal has to travel along the line. However, such low-resistive conductive material may deteriorate the adhesion property of data lines or gate lines to a substrate or may cause defects by interacting with other layers.

### SUMMARY OF THE INVENTION

The present invention provides a thin film transistor (TFT) substrate that may have an excellent signal transmission capability.

The present invention also provides a method of fabricating a thin film transistor (TFT) substrate that may have an excellent signal transmission capability.

Additional features of the invention will be set forth in the description which follows, and in part will be apparent from the description, or may be learned by practice of the invention.

The present invention discloses a TFT substrate. The TFT substrate includes an insulating substrate, a gate line and a data line formed on the insulating substrate, the data line crossing the gate line and being insulated from the gate line, wherein the gate line, the data line, or both the gate line and the data line comprises a base pattern formed on the insulating substrate, a low-resistive conductive pattern formed on the base pattern, and a passivation pattern formed on the low-resistive conductive pattern.

The present invention also discloses a method of fabricating a TFT substrate. The method includes forming a gate line and a data line on an insulating substrate. The data line crosses the gate line and is insulated from the gate line. The forming of the gate line, the data line, or both the gate line and the data line includes forming a low-resistive conductive pattern on a base pattern using an electroless plating method.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1, FIG. 2, FIG. 3, and FIG. 4 are cross-sectional views for explaining a method of fabricating a thin film transistor (TFT) substrate according to an exemplary embodiment of the present invention.

FIG. 5 is a cross-sectional view of a TFT substrate obtained using a method of fabricating a TFT substrate according to an exemplary embodiment of the present invention.

FIG. 6 is a cross-sectional view of a TFT substrate obtained using a method of fabricating a TFT substrate according to another exemplary embodiment of the present invention.

FIG. 7 and FIG. 8 are cross-sectional views of TFT substrates obtained using methods of fabricating a TFT substrate according to still other exemplary embodiments of the present invention.

FIG. 9 is a graph showing the variation of the thickness of low-resistive conductive patterns with respect to the amount of time for which the TFT substrate is dipped into a plating solution.

FIG. 10 is a graph showing the variation of the resistivity of a TFT substrate with respect to the thickness of low-resistive conductive patterns.

### DETAILED DESCRIPTION OF THE ILLUSTRATED EMBODIMENTS

The invention will now be described more fully hereinafter with reference to the accompanying drawings, in which exemplary embodiments of the present invention are illustrated. The invention may, however, be embodied in different forms and should not be construed as limited to the embodiments set forth herein. Rather, these embodiments are provided so that this disclosure will be thorough and complete, and will fully convey the scope of the present invention to those skilled in the art.

In the figures, the dimensions of layers and regions may be exaggerated for clarity of illustration. It will also be understood that when a layer or element is referred to as being "on" another layer or element, it can be directly on the other layer or element, or intervening layers may also be present. Further, it will be understood that when a layer is referred to as being "under" another layer or element, it can be directly under, and one or more intervening layers or elements may also be present. In addition, it will also be understood that when a layer or element is referred to as being "between" two layers or elements, it can be the only layer between the two layers or elements, or one or more intervening layers or elements may also be present. Like reference numerals refer to like elements throughout.

It will be understood that the order in which operating steps of each fabrication method disclosed in this disclosure are performed is not restricted to those set forth herein, unless specifically mentioned otherwise. Accordingly, the order in which operating steps of each fabrication method disclosed in this disclosure are performed can be varied within the scope of the present invention, and the resulting consequences that are obvious to one of ordinary skill in the art to which the present invention pertains will be regarded as being within the scope of the present invention.

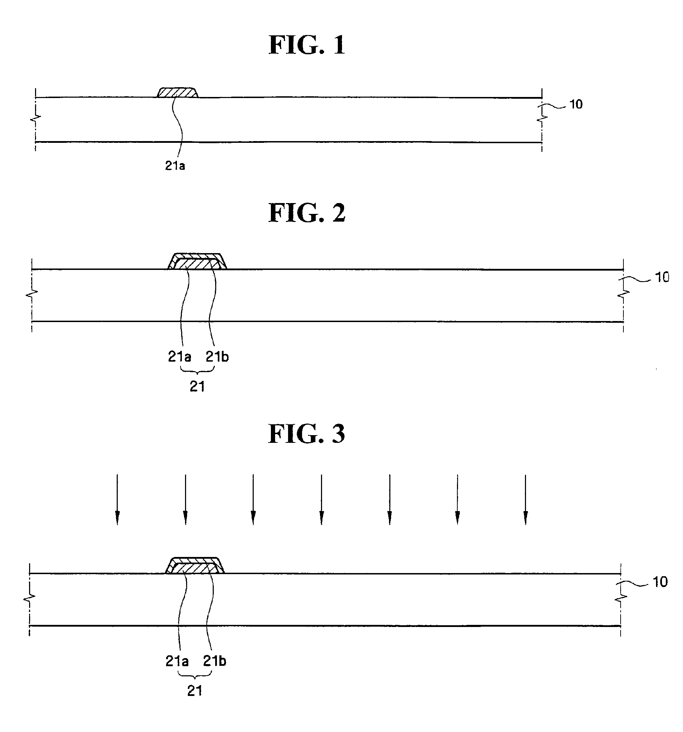

A method of fabricating a thin film transistor (TFT) substrate according to an exemplary embodiment of the present invention will be described below in detail with reference to FIG. 1, FIG. 2, FIG. 3, and FIG. 4, which are cross-sectional views for explaining the method.

Referring to FIG. 1, a base pattern 21a is formed on an insulating substrate 10. In detail, a base conductive layer (not shown) is formed on an insulating substrate 10, which may be made of an inorganic material such as glass or quartz or an organic material such as polymer resin. The base conductive layer may be formed of molybdenum (Mo), aluminum (Al), chromium (Cr), nickel (Ni), copper (Cu), titanium (Ti), tantalum (Ta), and tungsten (W) or an alloy of any of these materials. In particular, the base conductive layer may be formed of molybdenum (Mo) or molybdenum nitride (MoN), which may have excellent adhesion capability to upper layers. The base conductive layer may be formed to a thickness of about 200 - 1,000 Å using a sputtering method.

Thereafter, a photoresist layer (not shown) may be formed on the base conductive layer. The photoresist layer may be selectively exposed using an optical mask. The photoresist layer, which has photochemical properties that are changed by the exposure, is developed, thereby obtaining a photoresist pattern (not shown) having a desired shape.

Thereafter, a gate line base pattern may be formed by etching the base conductive layer using the photoresist pattern as an etching mask. The base pattern 21a, which is part of a gate electrode of a TFT, protrudes from the gate line base pattern. A gate pad base pattern (not shown), which transmits signals received from an external source, may be formed at one end of the gate line base pattern.

The photoresist pattern located on the gate line base pattern may then be removed using, for example, a stripper.

Thereafter, referring to FIG. 2, a low-resistive conductive pattern 21b is formed on the gate line base pattern. The low-resistive conductive pattern 21b may be formed using an electroless plating method, and it may cover the upper surface and side surface of the gate line base pattern. If the gate line base pattern is formed of molybdenum (Mo), the low-resistive conductive pattern 21b may be formed by first digesting the surface of the gate line base pattern in a plating solution containing a metal salt such as a palladium (Pd) salt, a platinum (Pt) salt, or a gold (Au) salt, so that the surface of the gate line base pattern can be plated with the metal salt.

Thereafter, the metal salt-plated gate line base pattern is digested in a plating solution containing a low-resistive metallic material so that a reduction process is caused by the metal salt on the gate line base pattern. As a result of the reduction process, a low-resistive conductive pattern 21b is formed only on the surface of the gate line base pattern. The low-resistive conductive pattern 21b may comprise copper (Cu), aluminum (Al), gold (Au), silver (Ag), or an alloy thereof. In particular, the low-resistive conductive pattern 21b may be formed of copper (Cu) or a copper alloy. The low-resistive conductive pattern 21b may be formed to a thickness of about 600 - 3,000 Å. When a gate line, a gate electrode 21, and a gate pad are formed as a double layer structure including the base pattern 21a and the low-resistive conductive pattern 21b, signals may be more uniformly transmitted across greater distances, thereby enabling the application of the present invention to wide-screen display devices.

If the gate line base pattern is formed of molybdenum nitride (MoN), an optional activation process may be performed on the surface of the gate line base pattern using a metal salt such as a palladium (Pd) salt, a platinum (Pt) salt, or a gold (Au) salt.

In detail, the optional activation process may be performed before an electroless plating process to facilitate the electroless plating process. The activation process may enhance the adhesion of the low-resistive conductive pattern 21b to the base pattern 21a and facilitate the generation of nuclei at an early stage. The activation process includes dipping the insulating substrate 10 having the base pattern 21a into a palladium (Pd)-based solution. As a result of the dipping, palladium nuclei may be generated on the base pattern 21a. The palladium particles serve as a catalyst surface.

The palladium-based solution may maintain a palladium concentration of 0.003 - 0.3 g/L. The density of palladium particles formed on the base pattern 21a may be 1×10⁸ - 1 × 10¹² palladium particles per square centimeter.

A pretreatment process may also be optionally performed in order to facilitate the activation of the surface of the low-resistive conductive pattern 21b and expedite the formation of the low-resistive conductive pattern 21b. The pretreatment process involves dipping the insulating substrate 10 having the base pattern 21a into a tin-based solution. The tin-based solution may maintain a tin concentration of 0.1 - 10 g/L. The density of tin/palladium particles formed on the base pattern 21a by the pretreatment process and the activation process is 5×10⁸ - 5×10¹² tin/palladium particles per square centimeter. The size of catalyst particles obtained by performing both the pretreatment process and the activation process may be less than the size of catalyst particles obtained by performing the activation process only. In addition, the density of catalyst particles obtained by performing both the pretreatment process and the activation process is higher than the density of catalyst particles obtained by performing the activation process only.

The pretreatment process can provide excellent results along with the activation process. However, the pretreatment process for adsorbing tin particles and the activation process for adsorbing palladium particles are optional.

A diffusion prevention layer (not shown) may be formed on the insulating substrate 10 before forming the gate line base pattern, thereby preventing the low-resistive conductive pattern 21b from infiltrating the insulating substrate 10. The diffusion prevention layer may be formed of a typical insulating material such as silicon nitride (SiNₓ), titanium nitride (TiNₓ), titanium oxide (TiOₓ), or tantalum oxide (TaOₓ).

The formation of a low-resistive conductive pattern using an electroless plating method does not involve the use of vacuum sputtering equipment. Thus, it may reduce the manufacturing cost and time of a TFT substrate as compared to a TFT substrate having a low-resistive conductive pattern formed using a sputtering method. The formation of a low-resistive conductive pattern using an electroless plating method may also provide a low-resistive conductive pattern with less thickness deviation and cause fewer interconnection defects.

Referring to FIG. 3, the insulating substrate 10 having the gate electrode 21, which includes the base pattern 21a and the low-resistive conductive pattern 21b, may be annealed. After annealing, the gate electrode 21 may have a resistivity of about 2.7 µΩcm or less. The annealing may be performed in a nitrogen (N₂) or argon (Ar) gas atmosphere at a temperature of about 40 - 400 °C for about 15 - 120 minutes.

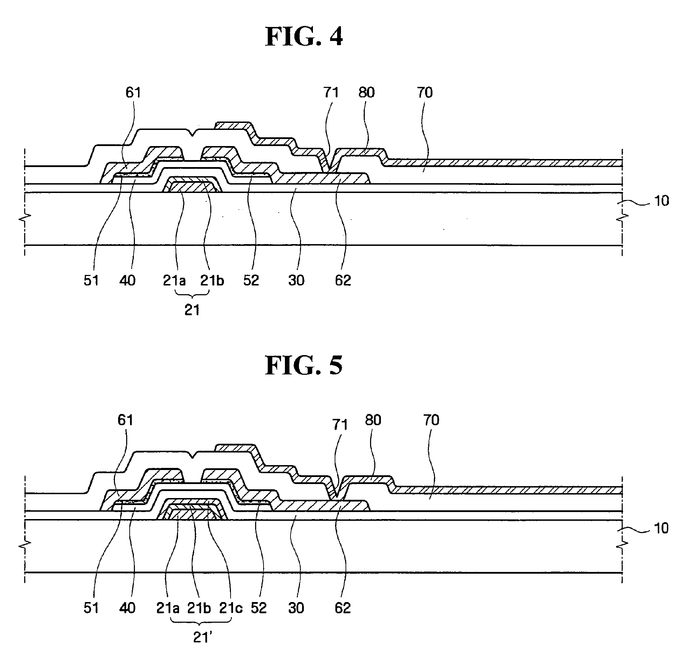

Referring to FIG. 4, a gate insulation layer 30 is formed on the entire surface of the insulation substrate 10 including the gate electrode 21. An amorphous silicon semiconductor layer (not shown) is then formed on the gate insulation layer 30, and a doped amorphous silicon layer (not shown) is formed on the semiconductor layer. A semiconductor layer 40 and a resistive contact layer 51, 52 may then be formed on a portion of the gate insulation layer 30 that corresponds to the gate electrode 21 by patterning the semiconductor layer and the doped amorphous silicon layer using a photolithography method that involves the use of masks.

Thereafter, a single-layered or multi-layered conductive layer (not shown) may be formed of molybdenum (Mo), chromium (Cr), tantalum (Ta) or an alloy of any of these materials on the surface of the insulating substrate 10, and photolithography, which involves the use of masks, is performed on the single-layered or multi-layered conductive layer, thereby forming a data line (not shown) that crosses a gate line (not shown), a source electrode 61, which is connected to the data line and extends above the gate electrode 21, a data pad (not shown), which is connected to one end of the data line and transmits signals received from an external source, and a drain electrode 62, which is spaced apart from the source electrode 61 and is on the opposite side of the gate electrode 21 from the source electrode 61.

Thereafter, an exposed portion of doped amorphous silicon layer (not shown) between the source electrode 61 and the drain electrode 62 may be removed to form the resistive contact layer 51, 52.

A passivation layer 70 is then formed on the entire surface of the insulating substrate 10 including the source electrode 61 and the drain electrode 62, and a contact hole 71 is formed in the passivation layer 70 to expose a portion of the drain electrode 62. The passivation layer 70 may be made of an organic insulation layer or an inorganic insulation layer including silicon nitride or silicon oxide.

Next, a transparent conductive layer (not shown) is formed on the entire surface of the insulating substrate 10, and a pixel electrode 80, which is electrically connected to the drain electrode 62 via the contact hole 71, is formed using a photolithography method that involves the use of masks, thereby completing the formation of a TFT substrate. The transparent conductive layer may be formed of a transparent conductive material such as indium tin oxide (ITO) or indium zinc oxide (IZO).

A method of fabricating a TFT substrate according to another exemplary embodiment of the present invention will be described in detail below with reference to FIG. 2, FIG. 3, FIG. 4, and FIG. 5. FIG. 5 is a cross-sectional view of a TFT substrate obtained using a method of fabricating a TFT substrate according to another exemplary embodiment of the present invention.

The embodiment shown in FIG. 5 is the same as the embodiment shown in FIGS. 1 through 4 except that it further includes forming a passivation pattern on a low-resistive conductive pattern as part of the formation of a gate line. Thus, the embodiment of FIG. 5 will be described focusing more on differences with the embodiment illustrated in FIGS. 1 through 4.

Referring to FIG. 5, a base pattern 21a is formed on an insulating substrate 10 using a photolithography method, and a low-resistive conductive pattern 21b is formed on the base pattern 21a using an electroless plating method so that the base pattern 21a can be covered by the low-resistive conductive pattern 21b, as described above with reference to FIG. 2. The base pattern 21a and the low-resistive conductive pattern 21b are then annealed, as described above with reference to FIG. 3.

Next, a passivation pattern 21c is formed on the low-resistive conductive pattern 21b, thereby forming a gate line (not shown), a gate electrode 21', and a gate pad (not shown). The passivation pattern 21c prevents the material of the low-resistive conductive pattern 21b from infiltrating and diffusing into other material layers. The passivation pattern 21c may include nickel (Ni), gold (Au), tin (Sn), zinc (Zn), titanium (Ti), or tantalum (Ta). In particular, the passivation pattern 21c may include nickel (Ni). The passivation pattern 21c may be formed using the same method used for forming the low-resistive conductive pattern 21b, i.e., an electroless plating method. Alternatively, the passivation pattern 21c may be formed by sequentially using an electroless plating method and an electroplating method. The passivation pattern 21c may be formed to a thickness of about 100 - 1,000 Å.

A gate insulation layer 30, a semiconductor layer 40, a resistive contact layer 51, 52, a data line, a passivation layer 70, and a pixel electrode 80 may be formed using practically the same methods as in the embodiment shown in FIGS. 1 through 4, and thus, detailed descriptions thereof will be omitted.

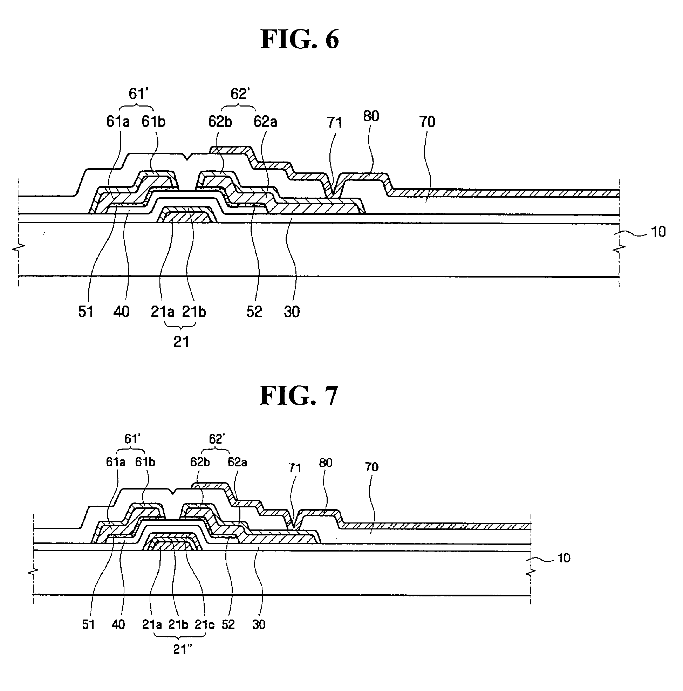

A method of fabricating a TFT substrate according to another exemplary embodiment of the present invention will be described in detail below with reference to FIG. 6, which is a cross-sectional view of a TFT substrate.

The embodiment of FIG. 6 is the same as the embodiment of FIGS. 1 through 4 except that it involves forming a data line using an electroless plating method. Thus, the embodiment of FIG. 6 will be described below by focusing more on differences with the embodiment of FIGS. 1 through 4.

Referring to FIG. 6, a base conductive layer (not shown) is formed on the entire surface of an insulating substrate 10 having a semiconductor layer 40 and a doped amorphous silicon layer (not shown). The base conductive layer may be formed of molybdenum (Mo), aluminum (Al), chromium (Cr), nickel (Ni), copper (Cu), titanium (Ti), tantalum (Ta), and tungsten (W) or an alloy thereof. In particular, the base conductive layer may be formed of molybdenum (Mo) or molybdenum nitride (MoN), which may exhibit excellent adhesion capability to upper layers. The base conductive layer may be formed to a thickness of about 200 - 1,000 Å using a sputtering method.

Thereafter, a photo resist layer (not shown) is formed on the base conductive layer and selectively exposed using an optical mask. The photo resist layer, which has photochemical properties that are changed by exposure, is developed, thereby obtaining a photoresist pattern (not shown) having a desired shape.

A data line base pattern, which crosses a gate line (not shown), a source electrode base pattern 61a, which protrudes from the data line base pattern, a data line pad base pattern, which is connected to one end of the data line base pattern and transmits signals received from an external source, and a drain electrode base pattern 62a, which is spaced apart from the source electrode base pattern 61a and is on the opposite side of a gate electrode 21 from the source electrode base pattern 61a, are formed by etching the base conductive layer using the photoresist pattern as an etching mask.

The photoresist pattern on the data line base pattern may then be removed using, for example, a stripper.

Thereafter, low-resistive conductive patterns 61b and 62b are formed on the data line base pattern. The low-resistive conductive patterns 61b and 62b may be formed using an electroless plating method, and they cover the data line base pattern. The low-resistive conductive patterns 61b and 62b may be formed using practically the same method as in the embodiment of FIGS. 1 through 4, and thus, detailed descriptions thereof will be omitted.

Thereafter, the insulating substrate 10 having a source electrode 61', which includes the source electrode base pattern 61a and the low-resistive conductive pattern 61b, and a drain electrode 62', which includes the drain electrode base pattern 62a and the low-resistive conductive pattern 62b, is annealed. After annealing, the source electrode 61' and the drain electrode 62' have a resistivity of about 2.7 µΩcm or less. The annealing may be performed in a nitrogen (N₂) or argon (Ar) gas atmosphere at a temperature of about 200 - 400 °C for about 15 - 120 minutes.

Thereafter, an exposed portion of the doped amorphous silicon layer (not shown) between the source electrode 61' and the drain electrode 62' may be removed to form the resistive contact layer 51, 52.

A passivation 70 and a pixel electrode 80 may be formed using practically the same methods as in the embodiment of FIGS. 1 through 4, and thus detailed descriptions thereof will be omitted.

A method of fabricating a TFT substrate according to another exemplary embodiment of the present invention will be described below in detail with reference to FIG. 7, which is a cross-sectional view of a TFT substrate.

The embodiment of FIG. 7 is the same as the embodiment of FIGS. 1 through 4 except that it includes forming a gate electrode 21" by forming a passivation pattern using an electroless plating method and forming a source electrode 61' and a drain electrode 62' by forming a source electrode base pattern 61a and a drain electrode base pattern 62a using a photolithography method and forming low-resistive conductive patterns 61b and 62b using an electroless plating method. Thus, a detailed description of the embodiment of FIG. 7 will be omitted.

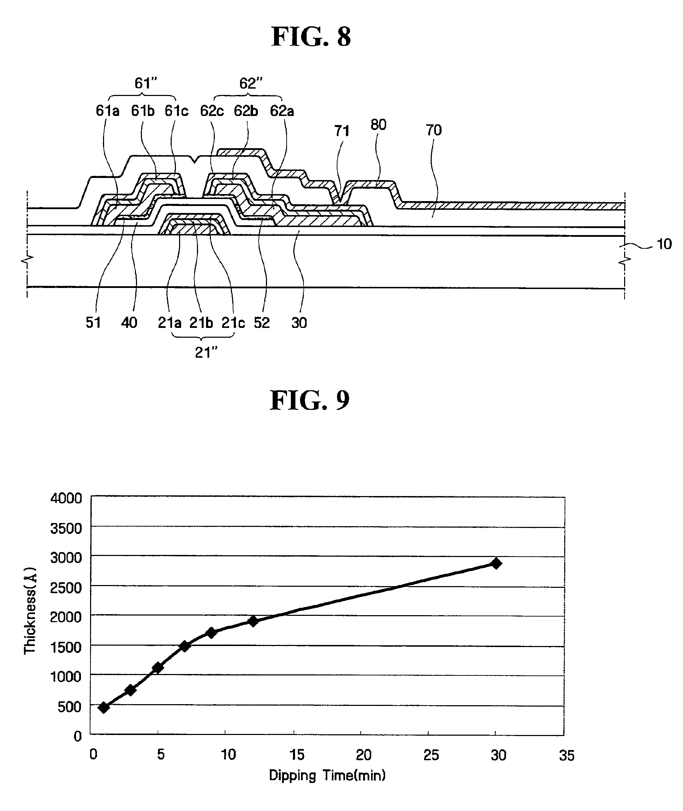

A method of fabricating a TFT substrate according to another exemplary embodiment of the present invention will be described in detail below with reference to FIG. 8, which is a cross-sectional view of a TFT substrate.

The embodiment of FIG. 8 is the same as the embodiment of FIGS. 1 through 4 except that it includes forming a gate electrode 21" by forming a passivation pattern using an electroless plating method and forming a source electrode 61" and a drain electrode 62" by forming a source electrode base pattern 61a and a drain electrode base pattern 62a using a photolithography method, forming low-resistive conductive patterns 61b and 62b using an electroless plating method and forming passivation patterns 61c and 62c using an electroless plating method. Thus, a detailed description of the embodiment of FIG. 8 will be omitted.

According to the above-mentioned exemplary embodiments, low-resistive interconnections that can be used in wide-screen display devices can be formed by forming multi-layered gate lines or data lines using an electroless plating method.

Further, the low-resistive metallic interconnections may be formed by forming gate lines, data lines, or both the gate lines and data lines using an electroless plating method, which does not need to use masks. The above-mentioned exemplary embodiments can also be applied to the formation of sustain electrode lines that are on a level with gate lines.

According to the above-mentioned exemplary embodiments, a TFT substrate may be fabricated by patterning a semiconductor layer and data lines using different masks. However, the above-mentioned embodiments can also be applied to the situation where a semiconductor layer and data lines are patterned using the same mask.

The above-mentioned exemplary embodiments can also be applied to the fabrication of a TFT substrate that includes a color filter layer.

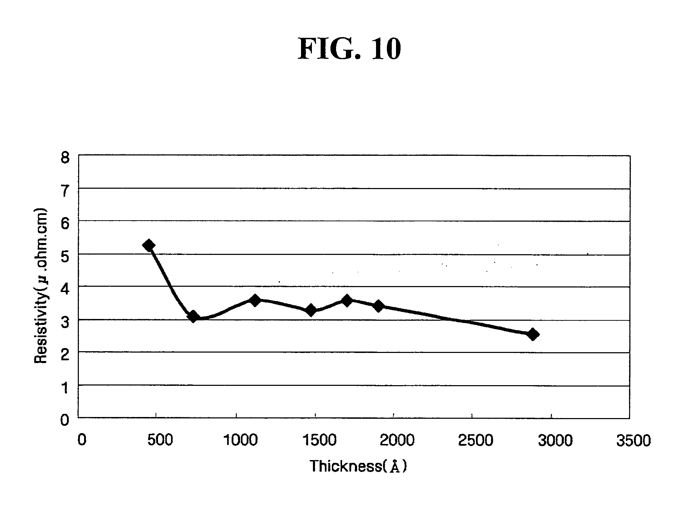

Variations in the property of a TFT substrate with respect to the thickness of low-resistive conductive patterns will be described in detail below with reference to FIG. 9 and FIG. 10. FIG. 9 is a graph showing the variation of the thickness of low-resistive conductive patterns with respect to the amount of time for which the TFT substrate is dipped into a plating solution ("the dipping time"), and FIG. 10 is a graph showing the variation of the resistivity with respect to the thickness of low-resistive conductive patterns.

Referring to FIG. 9, once the dipping time exceeds 3 minutes, the thickness of low-resistive conductive patterns 21b, 61b, and 62b of a TFT substrate obtained using a method of fabricating a TFT substrate according to an exemplary embodiment of the present invention drastically increases beyond about 600 Å.

Referring to FIG. 10, once the thickness of the low-resistive conductive patterns 21b, 61b, and 62b exceeds about 600 Å, the resistivity of the TFT substrate considerably decreases. According to exemplary embodiments of the present invention, the low-resistive conductive patterns 21b, 61b, and 62b can be quickly formed using an electroless plating method. If the low-resistive conductive patterns 21b, 61b, and 62b are formed to a thickness of about 600 - 3,000 Å, the resistivity of the low-resistive conductive patterns 21b, 61b, and 62b can be reduced to as low as 2.5 - 3.5 µΩcm.

As described above, according to exemplary embodiments of the present invention, it may be possible to fabricate a TFT substrate having excellent signal transmission capability and reduce the manufacturing cost and time of a TFT substrate by forming low-resistive metallic interconnections using an electroless plating method.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

**1.** A thin film transistor (TFT) substrate, comprising:
an insulating substrate,
a gate line and a data line formed on the insulating substrate, the data line crossing the gate line and being insulated from the gate line,
wherein the gate line, the data line, or both the gate line and the data line comprise a base pattern formed on the insulating substrate, a low-resistive conductive pattern formed on the base pattern, and a passivation pattern formed on the low-resistive conductive pattern

**2.** The thin film transistor (TFT) substrate of claim 1, wherein the base pattern comprises at least one of molybdenum, nickel, copper, aluminum, titanium, tantalum, tungsten, or chromium

**3.** The thin film transistor (TFT) substrate of claim 2, wherein the base pattern comprises molybdenum or molybdenum nitride.

**4.** The thin film transistor (TFT) substrate of claim 1, wherein the base pattern has a thickness of 200 to 1,000 Å

**5.** The thin film transistor (TFT) substrate of claim 1, wherein the low-resistive conductive pattern comprises at least one of copper (Cu), aluminum (Al), gold (Au), silver (Ag), or an alloy thereof.

**6.** The thin film transistor (TFT) substrate of claim 1, wherein the low-resistive conductive pattern has a thickness of 600 to 3,000 Å

**7.** The thin film transistor (TFT) substrate of claim 1, wherein the low-resistive conductive pattern covers the base pattern.

**8.** The thin film transistor (TFT) substrate of claim 7, wherein the low-resistive conductive pattern covers an upper surface and a side surface of the base pattern.

**9.** The thin film transistor (TFT) substrate of claim 1, wherein the passivation pattern comprises at least one of nickel (Ni), gold (Au), tin (Sn), zinc (Zn), titanium (Ti), or tantalum (Ta).

**10.** The thin film transistor (TFT) substrate of claim 1, wherein the passivation pattern has a thickness of 100 to 1,000 Å.

**11.** The thin film transistor (TFT) substrate of claim 1, further comprising a diffusion prevention layer that prevents the low-resistive conductive pattern from infiltrating the insulating substrate.

**12.** A method of fabricating a thin film transistor (TFT) substrate, comprising:
forming a gate line and a data line on an insulating substrate, the data line crossing the gate line and being insulated from the gate line,
wherein forming the gate line, the data line, or both the gate line and the data line comprises forming a low-resistive conductive pattern on a base pattern using an electroless plating method.

**13.** The method of claim 12, wherein the base pattern comprises at least one of molybdenum, nickel, copper, aluminum, titanium, tantalum, tungsten, or chromium.

**14.** The method of claim 13, wherein the base pattern comprises molybdenum or molybdenum nitride.

**15.** The method of claim 12, wherein the base pattern has a thickness of 200 to 1,000 Å.

**16.** The method of claim 12, wherein the low-resistive conductive pattern comprises at least one of copper (Cu), aluminum (Al), gold (Au), silver (Ag), or an alloy thereof.

**17.** The method of claim 12, wherein the low-resistive conductive pattern has a thickness of 600 to 3,000 Å.

**18.** The method of claim 12, further comprising annealing the insulating substrate on which the base pattern and the low-resistive conductive pattern are formed.

**19.** The method of claim 18, wherein the annealing comprises annealing the insulating substrate in a nitrogen gas or argon gas atmosphere at a temperature of 40 to 400°C for 15 to 120 minutes.

**20.** The method of claim 12, further comprising forming a passivation pattern on the low-resistive conductive pattern.

**21.** The method of claim 20, wherein the passivation pattern comprises at least one of nickel (Ni), gold (Au), tin (Sn), zinc (Zn), titanium (Ti), or tantalum (Ta).

**22.** The method of claim 20, wherein the passivation pattern has a thickness of 100 to 1,000 Å.

**23.** The method of claim 12, further comprising performing an activation process on the base pattern.

**24.** The method of claim 23, wherein performing the activation process comprises adsorbing palladium.

**25.** The method of claim 24, wherein performing the activation process comprises dipping the base pattern into a solution comprising palladium.

**26.** The method of claim 25, wherein the solution has a palladium concentration of 0.003 - 0.3 g/L.

**27.** The method of claim 24, wherein performing the activation process comprises forming a density of 1×10⁸ to 1×10¹² palladium particles per square centimeter on the base pattern.

**28.** The method of claim 23, further comprising performing a pretreatment process 29.
The method of claim 28, wherein the pretreatment process comprising adsorbing tin particles on the base pattern.

**30.** The method of claim 29, further comprising:
annealing the insulating substrate on which the base pattern and the low-resistive conductive pattern are formed; and
forming a passivation pattern on the low-resistive conductive pattern.

**31.** The method of claim 29, wherein performing the pretreatment process comprises dipping the base pattern into a solution comprising tin at a concentration of 0.1 - 10 g/L.

**32.** The method of claim 12, further comprising forming a diffusion prevention layer that prevents the low-resistive conductive pattern from infiltrating the insulating substrate.
